# EUROPEAN PATENT SPECIFICATION

(11) **EP 1 580 884 B1**
(45) Date of publication and mention of the grant of the patent: **30.05.2007**
(21) Application number: 05101137.7
(22) Date of filing: 15.02.2005
(51) Int. Cl.: H03G 9/02

(54) **Dynamic equalizing**
Dynamische Entzerrung
Egalisation dynamique

(30) Priority: 26.03.2004 US 811266
(43) Date of publication of application: 28.09.2005
(73) Proprietor: BOSE CORPORATION, Framingham, Massachusetts 01701-9168 (US)
(72) Inventor: Berardi, William, 01701-9168, Framingham (US); Kulkarni, Abhijit, 01701-9168, Framingham (US)
(74) Representative: Brunner, Michael John

(56) References cited:
- US-A1- 2002 076 072
- PATENT ABSTRACTS OF JAPAN vol. 010, no. 179 (E-414), 24 June 1986 (1986-06-24) & JP 61 029205 A (HITACHI LTD), 10 February 1986 (1986-02-10)
- PATENT ABSTRACTS OF JAPAN vol. 013, no. 551 (E-857), 8 December 1989 (1989-12-08) & JP 01 228206 A (MATSUSHITA ELECTRIC IND CO LTD), 12 September 1989 (1989-09-12)

## Description

The present invention relates in general to dynamic equalizing, and more particularly concerns dynamic equalizing incorporating level sensing and manually selected volume sensing.

### BACKGROUND OF THE INVENTION

For background, reference is made to U.S. Patent Nos. RE37,223 and 5,361,381. Further dynamic equalizing apparatuses and methods are known from PATENT ABSTRACTS OF JAPAN vol. 010, no. 179 (E-414), 24 June 1986 (1986-06-24) & JP 61 029205 A (HITACHI LTD), 10 February 1986 (1986-02-10), PATENT ABSTRACTS OF JAPAN vol. 013, no. 551 (E-857), 8 December 1989 (1989-12-08) & JP 01 228206 A (MATSUSHITA ELECTRIC IND CO LTD), 12 September 1989 (1989-09-12) or US 2002/076072 A1. It is an important object of the invention to provide improved dynamic equalizing.

### SUMMARY OF THE INVENTION

Frequency response is adjusted dynamically in response to level sensing of an input signal and the setting of the manually set volume control, where the level sensing occurs before the signal is delivered to the manually set volume control.

According to an aspect of the invention, time constants for frequency response changes are established for reducing compressor artifacts. Another feature for reducing compressor artifacts includes limiting the minimum value of the detected input.

Other features, objects and advantages of the invention will become apparent from the following detailed description when read in connection with the accompanying drawing in which:

### BRIEF DESCRIPTION OF THE SEVERAL VIEWS OF THE DRAWING

FIG. 1 shows the logical arrangement of a system according to the invention; and
FIG. 2 is a block diagram of portions of a radio embodying the invention.

### DETAILED DESCRIPTION

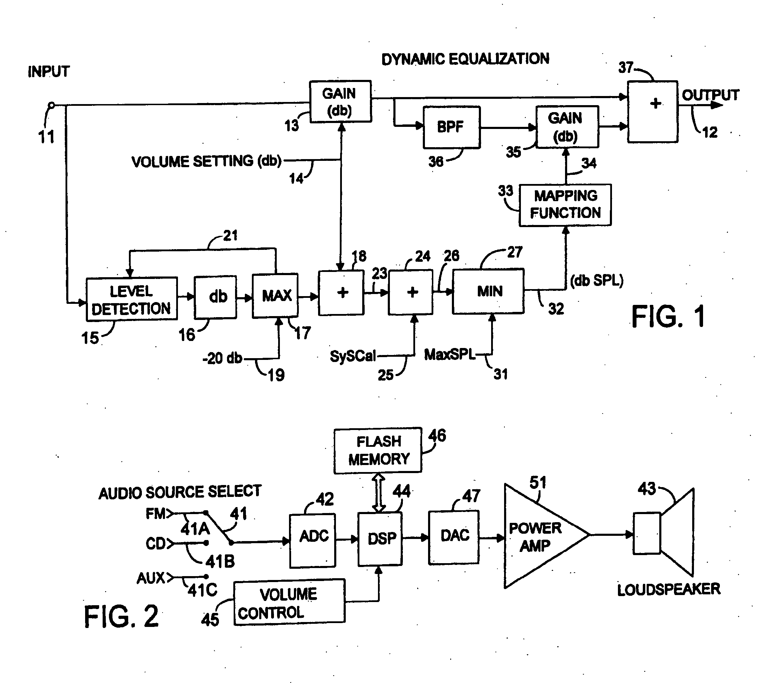

With reference now to the drawing and more particularly FIG. 1, there is shown a block diagram illustrating the logical arrangement of a system according to the invention. The invention may be embodied in hardware or a combination of hardware and software, and may be accomplished using analog circuits, digital signal processing techniques or a combination. A specific embodiment has a flash memory storing program instructions for a digital signal processor chip.

The system processes an input audio signal on input terminal 11 to provide an output signal dynamically equalized according to the invention on output terminal 12. The input signal on terminal 11 is delivered to manually controlled volume control 13 whose gain is set by a manually set volume setting signal on line 14 that is also delivered to adder 18. The input signal on terminal 11 is also delivered to level detector 15. Level detector 15 is typically a peak detector, although other level detectors may also be used. Level detector 15 provides a linear signal representative of the level of the input signal, which is then logarithmically processed 16 to furnish a signal to Max 17 that is representative of the input signal level in decibels (db). In one embodiment, the detected level for a full scale input signal is scaled to be 0 dB. Constant 19, which has a value of 20 dB, is used to set the range of allowable output values for Max 17, which is between 0 dB and -20 dB in this example. However, other values can be chosen for constant 18. Max 17, comprising a limiter, feeds its output back to level detector 15 to limit the minimum level to which the output of level detector 15 is allowed to decay. For example, if the level of input signal 11 drops below -20 dB re full scale, feedback signal 21 from Max 17 does not allow the output of level detector 15 to drop below - 20 dB. Adder 18 delivers a first sum signal on line 23 to a second adder 24 that receives a system calibration constant on line 25. Adders 18 and 24 could also be combined into a single addition operation if desired. The system calibration constant added to the output of adder 18 provides a calibrated sum signal on output line 26 that is delivered to minimum level controller 27.

The SysCal constant is representative of the specific system in which the invention is used. SysCal is the number that when added to the value present at the output of adder 18 gives an estimate representative of the SPL (sound pressure level) obtained (available on line 26) when the associated sound system in which the invention is incorporated is operating in a typical room (assuming that the amplifier is functioning in its linear range). It compensates for any gain present in the system between the output of adder 18 and the actual SPL present, including amplifier gain, transducer gain (from electrical input to SPL output), and room gain. One method of determining SysCal for a particular embodiment involves operating a system employing the invention in a representative room. The output of adder 18, and the sound pressure present in the room (measured in dBSPL) are measured simultaneously. The difference between these values is the SysCal value. For a specific radio embodying the invention the SysCal constant is 114 db.

Minimum level controller 27 limits the maximum estimate of the output sound pressure level to a level set by the Max SPL constant on line 31, about 90 db for the aforesaid specific radio. The Max SPL constant is chosen to approximately match the maximum SPL that the electroacoustic system can produce in a typical room, and accounts for the large signal behavior of the system. Minimum level controller 27 keeps the estimate of sound pressure level from significantly exceeding the actual SPL present in the environment in which a system employing the invention is used, when the system operates at or near its maximum output capability. Over estimation of the SPL present in the environment would result in too little dynamic equalization being applied to the system. The combination of Max SPL constant and Minimum level controller 27 are used to compensate for the fact that under large signal conditions, the system gain (primarily the electrical gain but may also include the gain of the acoustic system) decreases. At some point as the input signal level increases, the output sound pressure level will no longer increase.

A typical system may include a system limiter that can be used to keep the system amplifier from clipping. The limiter achieves this by dynamically reducing system (electrical) gain when a signal is presented to the amplifier input that would be large enough to cause the amplifier to clip. Rather than using a Max SPL constant as described, the SPL estimate could be limited by a modified value that dynamically tracked the system gain. An output from a system limiter could be fed back to Minimum level controller 27 to keep the SPL estimate from exceeding the actual SPL present in the environment.

Minimum level controller 27 provides an output signal on line 32 that is an estimate of sound pressure level encountered by a listener listening to an audio system with electroacoustic devices (amplifiers and loudspeakers, not shown) driven by output signal 12. The SPL estimate signal is delivered to loudness mapping function 33 via line 32. Mapping function 33 determines the relationship between the SPL esti mate and the gain signal provided on line 34 to gain controller 35. Mapping function 33 is typically configured as a lookup table, but could also be calculated from a function generated to describe the desired mapping behavior. The form of the mapping function depends on the topology of the elements used to dynamically equalize the desired signal. Derivation of a representative mapping function for an embodiment employing the topology shown in Fig. 1 is described below. The mapping function describes a relationship between low frequency equalization and sound pressure level. The relationship is independent of the system in which it is used, except for topology. It is also possible to construct a mapping function that is completely independent of the system, including topology. In this case, a separate block would be needed to translate the mapping function for use with a particular topology.

Use in different systems of the dynamic EQ described herein would typically require modification of SysCal and Max SPL constants, but not require change to the mapping function. It should be noted that it is also possible to incorporate SysCal and Max SPL functions into a single mapping function, if desired. Such an arrangement would work identically to the system of Fig. 1, except that the mapping function would no longer be independent of the system in which it was used, which complicates the manufacture of multiple devices. The structure of Fig. 1 separates system dependent and system independent functions out for improved portability of the invention across products.

Gain controller 35 controls the level of the output signal provided by band pass filter 36, which typically has a center frequency at the lowest frequency radiated by the system and is energized by the output of manually controlled volume control 13, that is provided to output adder 37. Output adder 37 combines the manually controlled input signal with the signal provided by gain controller 35 to provide the output signal on output 12 that is dynamically equalized according to the invention. In effect, the resultant signal has spectral components between about 200 Hz and the center frequency of band pass filter 36 that are progressively amplified as a function of frequency that increases as frequency decreases by an amount related to both the sensed input level and the volume control setting, as determined by mapping function or lookup table 33.

Mapping function 33 for an embodiment employing the topology of Fig. 1 can be derived from the data graphically represented in FIG. 6 of the aforesaid U.S. Pat. No. RE37,223. The top curve of Fig. 6 is associated with a level of 94 dBSPL. The center frequency of bandpass filter 36 is associated with the low frequency peak of the family of curves, in this embodiment approximately 50 Hz. Derivation of a mapping parameter for the curve in Fig. 6 marker 65% will be illustrated. The 65% curve corresponds to an SPL of approximately 71 dBSPL. The curve (looking at high frequencies where no bass boost is active) is approximately 23 dB lower than the top curve, which is referenced t94 dBSPL. The required gain of gain block 36, for an estimated SPL of 71 dBSPL, is determined by comparing the magnitude of the 65% curve at the low frequency peak (50 Hz) to the magnitude at high frequencies. For the 65% curve, the high frequency level is approximately -10.5 dB and the level of the peak is approximately -2 dB. Therefore, the gain should be approximately 8.5 dB dB. Values for other estimated SPL levels can be determined in a similar manner, and the resulting values entered into a lookup table. Values for SPL estimates that fall between the curves shown in Fig. 6 can be interpolated. Alternatively, a polynomial or other function could be fit to the series of value s obtained, and the function calculated whenever a gain value is needed.

The present invention has a number of advantages. By level sensing prior to delivering the signal to the manually set volume control, the advantage of volume control setting responsiveness is obtained. The responsiveness of dynamic equalizing to volume control changes and signal level changes may be set independently. It is preferable that dynamic equalizing that compensates for changes in volume control setting occur instantaneously (although time constants can be associated with these changes if desired) whereas dynamic equalizing that compensates for changes in input signal level have time constants applied to reduce audible artifacts (time constants are discussed in more detail below). This arrangement avoids momentary loss of bass that may occur for some length of time in a level sensing dynamic equalization system when the input signal level is reduced as a result of manual reduction of system volume. Embodiments of the present invention allow different time constants to be used for equalization adjustment associated with manual volume level adjustments and signal level variations.

In one embodiment, the side chain processing (the side chain consisting of elements 15 - 19, 21, 23-27, 31, 32, 33) is done in blocks. 256 samples (approximately 5.8 msec of audio data) are acquired and processed. Level detector 15 calculates the RMS value of the samples in a block, dB 16 converts this calculated value into a logarithmic value, and Max 17 limits the range of variation of these block values to 20 dB, and provides feedback to level detector 15 as previously discussed. The block size chosen fundamentally determines how quickly the level detector can change when the input level changes. The attack time constant is therefore related to the block size chosen, and in this example is approximately 5.8 msec. The decay time constant is chosen to reduce audible artifacts associated with dynamically changing the equalization applied. In one embodiment, the decay time constant is chosen to be on the order of 10 seconds, although longer time constants, such as about 20 seconds may be desirable.

An exemplary code for input level sensing follows:
k = p->dyneq.timeConstant; // current value = 0.99942 floating point = exp(-1/1723), about 7 frames = 256*7
p->dyneq.slower_smoothed_rms = MAX(m, scalarMult(k, p->dyneq.slower smoothed_rms))

In other words, this approach is a fast attack and slow decay approach. Every frame, 256 samples (or about 5.8 msec) of data are acquired. The mean square signal (m) of the frame (or block) of 256 data samples is measured. If that (m) is bigger than the slowly decaying last estimate (called p.slower_smoothed_rms) then it (m) immediately becomes the new estimate, otherwise the old estimate is decayed with a time constant of 10 seconds.

Since the side chain processing is done on a block basis, the output of the mapping function 33 changes approximately once every 5.8 msec, which causes gain 35 to change once every 5.8 msec. A one pole low pass filter having a cutoff of 40 Hz is placed between the output of the mapping function and gain element 35 to smooth the gain changes to reduce audible artifacts (such as stairstep or zipper noise) that might otherwise be perceptible if the gain 35 were to change in a stepwise fashion. Furthermore, time constants associated with signal level variations can be selected to reduce artifacts associated with time varying gains. Still a further advantage resides in reducing artifacts by limiting the minimum value of the detected input. Since the level detector need not accommodate the full dynamic range of the volume control, its range of values can be limited to the expected variation in source signal levels, typically of the order of 20 dB but may be smaller, compared with 60 db or more for post-volume detection. Furthermore, limiting the dynamic range of the level detector has the advantage of reducing the maximum error possible during a transient event, such as excess bass during a sudden attack which follows a quiet passage.

The invention typically forms an estimate of the sound pressure level (SPL) in the room by first detecting the input signal and converting it from a linear range to a logarithmic range in decibels (db). This detected level is limited to a range of values wide enough to accommodate the expected input sources. The volume setting is then added to the detected level to find the effective electrical input level to the dynamic equalizer. A scale factor (SysCal) is then added to form an estimate of the SPL in the room. This estimate is then bounded to an upper limit to account for limitations of the playback system. The final SPL estimate is then used as an input to the desired loudness mapping function which creates the necessary band pass filter gain.

Referring to FIG. 2, there is shown a block diagram illustrating the logical arrangement of a radio portion embodying the invention. An audio input signal selected by switch 41 and delivered to the input of input analog-to-digital converter 42 is reproduced by loudspeaker 43 dynamically equalized according to the invention. The audio input signal, which may be an FM signal on terminal 41A, a CD signal on terminal 41 B or an auxiliary signal, such as from a television, on terminal 41C is delivered to the input of analog-to-digital converter 42 to provide a corresponding digital signal that is delivered to digital signal processor 44 that receives a volume control setting signal from volume control 45 and exchanges digital information with flash memory 46 that has stored therein the program instructions referred to above and on the appended CD -ROM identified above. Digital signal processor 44 provides a dynamically equalized digital signal processed in the manner described above to digital-to-analog converter 47 that provides a corresponding dynamically equalized signal to the input of power amplifier 51 that energizes loudspeaker 42.

There has been described novel apparatus and techniques for dynamic equalizing. It is evident that those skilled in the art may now make numerous uses and modifications of and departures from the specific embodiments described herein without departing from the inventive concepts, the scope of the invention being defined by the claims.

## Claims

1. Dynamic equalizing apparatus comprising,
an input terminal (11) and an output terminal (12),
an output adder (37) having first and second inputs,
a manually controlled volume controller (13) intercoupling said input terminal and said first input,
a level detector (15) having its input coupled to said input terminal (11) and providing a level signal representative of the level on sa id input terminal,
a level adder (18) having a first input for receiving said level signal and a second input coupled to said manually controlled volume controller (13) receiving a signal representative of the manually controlled volume setting to provide a combined level volume setting signal,
a band pass filter (36) having its input coupled to the output of said manually controlled volume controller (13) and having a center frequency at a predetermined bass frequency,
a lookup table (33) having its input coupled to the output of said level setting adder (18) and providing a gain signal representative of a desired gain that is dependent upon the input signal level and the manually set volume controller setting,
and a gain controller (35) coupling the band pass filter to the second input of said output adder and coupled to the lookout table (33) output and responsive to the latter output for establishing said desired gain.

2. Dynamic equalizing apparatus in accordance with claim 1 wherein there is apparatus limiting the detected input level to a minimum value.

3. Dynamic equalizing apparatus in accordance with claim 1 wherein the apparatus includes apparatus (27) limiting the signal delivered to the lookup circuitry (33) to a signal representative of a predetermined maximum value.

4. Dynamic equalizing apparatus in accordance with claim 1 and further comprising an output limiter and a feedback path to the level detector from the limiter constructed and arranged to account for the loss of system gain during limiting.

5. Dynamic equalizing apparatus in accordance with claim 1 constructed and arranged to have a first attack time constant associated with said level detector (15) different from a second decay time constant associated with said level detector.

6. Dynamic equalizing apparatus in accordance with claim 5 wherein said first time constant is a fast attack time constant and said second time constant is a slow decay time constant.

7. A method of dynamic equalizing comprising,
sensing the level of an input audio signal to provide a sensed input level signal,
sensing the setting of a manually operated volume control (13),
the sensing of said input audio signal level occurring before the input signal is delivered to said manually operated volume control (13),
processing the audio signal after having its volume adjusted by said manually set volume control (13) with an adjustable frequency response adjusted in response to both the sensed input level signal and the manually operated volume control setting,
and limiting the dynamic range of the sensed input level signal.

8. A method of dynamic equalizing in accordance with claim 7 and further comprising,
adding said input level signal and said manually controlled volume control setting signal to provide a combined level volume setting signal,
applying the output of the manually controlled volume controller (13) to a filter (36) of bass spectral components **characterized by** a center frequency at a predetermined bass frequency,
processing the combined level volume setting signal to provide a signal representative of a desired gain that is dependent upon the input signal level and the manually set volume control setting.
applying the output of the filter (36) to a gain controller (35) having its gain set to said desired gain,
and adding the output of said gain controller (35) to the manually controlled volume controller output signal to provide a dynamically equalized output signal.

9. A method of dynamic equalizing in accordance with claim 8 wherein processing the combined level volume signal includes applying the latter signal to a lookup table (33) to provide said signal representative of a desired gain.

10. A method in accordance with claim 7 and allowing the sensed input level signal to increase in accordance with a first attack time constant and decrease in accordance with a second decay time constant different from said first time constant.

11. Dynamic equalizing apparatus comprising,
an input terminal (11) and an output terminal (12),
a manually controlled volume controller (13) between said input terminal (11) and said output terminal (12).
a level detector (15) having its input coupled to said input terminal and providing a level signal representative of the level on said input terminal (11),
a limiter (17) coupled to said level detector (15) constructed and arranged to limit the dynamic range of said level signal,
a filter (36) having its input coupled to the output of said manually controlled volume controller (13),
a signal processor between the level detector (15) and the filter (36) constructed and arranged to provide a gain signal representative of a desired gain that is dependent upon the input signal level and the manually set volume controller setting, and
a gain controller (35) tween the filter (36) and said output constructed and arranged to establish said desired gain in response to said gain signal.

## Patentansprüche

1. Vorrichtung zur dynamischen Entzerrung umfassend,
einen Eingangsanschluss (11) und einen Ausgangsanschluss (12),
einen Ausgangsaddierer (37) mit ersten und zweiten Eingängen,
einen manuell gesteuerten Lautstärkekontroller (13), der den Eingangsanschluss und den ersten Eingang miteinander verbindet,
einen Pegeldetektor (15), dessen Eingang mit dem Eingangsanschluss (11) verbunden ist und ein Pegelsignal bereit stellt, das den Pegel an dem Eingangsanschluss angibt,
einen Pegeladdierer (18) mit einem ersten Eingang zum Empfang des Pegelsignals und einen zweiten mit dem manuell gesteuerten Lautstärkekontroller (13) gekoppelten Eingang, der ein Signal empfängt, das die manuell gesteuerte Lautstärkeeinstellung angibt, um ein kombiniertes Pegel-Lautstärkeeinstellungs-Signal bereit zu stellen,
ein Bandpassfilter (36), dessen Eingang mit dem Ausgang des manuell gesteuerten Lautstärkekontrollers (13) gekoppelt ist und der eine Mittenfrequenz bei einer vorbestimmten Bassfrequenz aufweist,
eine Nachschlagetabelle (33), deren Eingang mit dem Ausgang des Pegeleinstelladdierers (18) gekoppelt ist und die ein Verstärkungssignal bereit stellt, das eine gewünschte Verstärkung angibt, die von dem Eingangssignalpegel und der manuell eingestellten Lautstärkekontrollereinstellung abhängt,
und einen Verstärkungskontroller (35), der das Bandpassfilter mit dem zweiten Eingang des Ausgangsaddierers koppelt und der mit den Ausgang der Nachschlagetabelle (33) gekoppelt ist und auf den letzteren Ausgang anspricht, um die gewünschte Verstärkung einzustellen.

2. Vorrichtung zum dynamischen Entzerren gemäß Anspruch 1, bei der es eine Vorrichtung gibt, die den detektierten Eingangspegel auf einen minimalen Wert begrenzt.

3. Vorrichtung zum dynamischen Entzerren gemäß Anspruch 1, wobei die Vorrichtung eine Vorrichtung (27) aufweist, die das der Nachschlageschaltkreisanordnung (33) gelieferte Signal auf ein Signal begrenzt, das einen vorbestimmten maximalen Wert angibt.

4. Vorrichtung zum dynamischen Entzerren gemäß Anspruch 1 und ferner mit einem Ausgabebegrenzer und einem Rückkopplungspfad von dem Begrenzer zu dem Pegeldetektor, der aufgebaut und angeordnet ist, um den Verlust der Systemverstärkung beim Begrenzen zu berücksichtigen.

5. Vorrichtung zum dynamischen Entzerren gemäß Anspruch 1, die aufgebaut und ausgelegt ist, um eine erste, dem Pegeldetektor (15) zugeordnete Einschwingzeitkonstante aufzuweisen, die sich von einer zweiten, dem Pegeldetektor zugeordneten Abfallzeitkonstante unterscheidet.

6. Vorrichtung zum dynamischen Entzerren gemäß Anspruch 5, bei der die erste Zeitkonstante eine schnelle Einschwingzeitkonstante ist und die zweite Zeitkonstante eine langsame Abfallzeitkonstante ist.

7. Verfahren zum dynamischen Entzerren, umfassend,
Erfassen des Pegels eines Eingangsaudiosignals, um ein erfasstes Eingangspegelsignal bereit zu stellen,
Erfassen der Einstellung einer manuell betriebenen Lautstärkesteuerung (13),
wobei das Erfassen des Eingangsaudiosignalpegels erfolgt, bevor das Eingangssignal der manuell betriebenen Lautstärkesteuerung (13) zugeführt wird,
Verarbeiten des Audiosignals, nachdem dessen Lautstärke durch die manuell festgelegte Lautstärkesteuerung (13) mit einer einstellbaren Frequenzantwort eingestellt ist, die in Antwort sowohl auf das erfasste Eingangspegelsignal als auch die manuell betriebene Lautstärkesteuerungeinstellung eingestellt wird,
und Begrenzen des dynamischen Bereichs des erfassten Eingangspegelsignals.

8. Verfahren zum dynamischen Entzerren gemäß Anspruch 7 und ferner umfassend,
Addieren des Eingangspegelsignals und des manuell gesteuerten Lautstärkesteuereinstellsignals, um ein kombiniertes Pegel-Lautstärkeeinstellungs-Signal bereit zu stellen,
Anlegen der Ausgabe des manuell gesteuerten Lautstärkekontrollers (13) an ein Filter (36) für Bassspektralkomponenten, die durch eine Mittenfrequenz bei einer vorbestimmten Bassfrequenz **gekennzeichnet** sind,
Verarbeiten des kombinierten Pegel-Lautstärkeeinstellungs-Signals, um ein Signal bereit zu stellen, das eine gewünschte Verstärkung angibt, die von dem Eingangssignalpegel und der manuell eingestellten Lautstärkesteuerungseinstellung abhängt,
Anlegen der Ausgabe des Filters (36) an einen Verstärkungskontroller (35), dessen Verstärkung auf die gewünschte Verstärkung eingestellt wird,
und Addieren der Ausgabe des Verstärkungskontrollers (35) zu dem Ausgangssignal des manuell gesteuerten Lautstärkekontrollers, um ein dynamisch entzerrtes Ausgangssignal bereit zu stellen.

9. Verfahren zum dynamischen Entzerren gemäß Anspruch 8, bei dem das Verarbeiten des kombinierten Pegel-Lautstärke-Signals umfasst, das letztere Signal an eine Nachschlagetabelle (33) anzulegen, um das Signal bereit zu stellen, das eine gewünschte Verstärkung angibt.

10. Verfahren gemäß Anspruch 7 und ermöglichend, das erfasste Eingangspegelsignal gemäß einer ersten Einschwingzeitkonstante zu erhöhen und gemäß einer zweiten Abfallzeitkonstante, die sich von der ersten Zeitkonstante unterscheidet, zu verringern.

11. Vorrichtung zum dynamischen Entzerren, umfassend,
einen Eingangsanschluss (11) und einen Ausgangsanschluss (12),
einen manuell gesteuerten Lautstärkekontroller (13) zwischen dem Eingangsanschluss (11) und dem Ausgangsanschluss (12),
einen Pegeldetektor (15), dessen Eingang mit dem Eingangsanschluss gekoppelt ist und der ein Pegelsignal bereit stellt, das den Pegel an dem Eingangsanschluss (11) angibt,
einen mit dem Pegeldetektor (15) gekoppelten Begrenzer (17), der aufgebaut und ausgelegt ist, den dynamischen Bereich des Pegelsignals zu begrenzen,
ein Filter (36), dessen Eingang mit dem Ausgang des manuell gesteuerten Lautstärkekontrollers (13) gekoppelt ist,
einen Signalprozessor zwischen dem Pegeldetektor (15) und dem Filter (36), der aufgebaut und ausgelegt ist, um ein Verstärkungssignal bereit zu stellen, das eine gewünschte Verstärkung angibt, die von dem Eingangssignalpegel und der manuell eingestellten Lautstärkekontrollereinstellung abhängt und
einen Verstärkungskontroller (35) zwischen dem Filter (36) und dem Ausgang, der aufgebaut und ausgelegt ist, um die gewünschte Verstärkung in Antwort auf das Verstärkungssignal einzustellen.

## Revendications

1. Dispositif d'égalisation dynamique comprenant,
une borne d'entrée (11) et une borne de sortie (12),
un additionneur de sortie (37) ayant des première et seconde entrées,
un organe de commande du volume (13) contrôlé manuellement couplant entre elles ladite borne d'entrée et ladite première entrée,
un détecteur de niveau (15) ayant son entrée couplée à ladite borne d'entrée (11) et fournissant un signal de niveau représentatif du niveau présent sur ladite borne d'entrée,
un additionneur de niveau (18) ayant une première entrée pour recevoir ledit signal de niveau et une seconde entrée couplée audit organe de commande du volume (13) contrôlé manuellement recevant un signal représentatif du réglage du volume contrôlé manuellement destiné à fournir un signal à niveaux combinés de réglage du volume,
un filtre passe-bande (36) ayant son entrée couplée à la sortie dudit organe de commande du volume (13) contrôlé manuellement et ayant une fréquence centrale située à une fréquence basse déterminée,
une table de conversion (33) ayant son entrée couplée à la sortie dudit additionneur de réglage du niveau (18) et fournissant un signal de gain représentatif d'un gain souhaité qui est dépendant du niveau du signal d'entrée et du réglage de l'organe de commande du volume réglé manuellement,
et un organe de commande du gain (35) couplant le filtre passe-bande à la seconde entrée dudit additionneur de sortie et couplé à la sortie de la table de conversion (33) et répondant à cette dernière sortie pour établir ledit gain souhaité.

2. Dispositif d'égalisation dynamique selon la revendication 1 dans lequel il y a un dispositif limitant le niveau d'entrée détecté à une valeur minimale.

3. Dispositif d'égalisation dynamique selon la revendication 1 dans lequel le dispositif comprend un dispositif (27) limitant le signal envoyé vers les circuits de conversion (33) à un signal représentatif d'une valeur maximale déterminée.

4. Dispositif d'égalisation dynamique selon la revendication 1 et comprenant en outre un limiteur de sortie et un trajet de rétroaction vers le détecteur de niveau depuis le limiteur construit et organisé pour tenir compte de la perte du gain du système pendant la limitation.

5. Dispositif d'égalisation dynamique selon la revendication 1 construit et organisé pour avoir une première constante de temps d'attaque associée audit détecteur de niveau (15) différente d'une seconde constante de temps de diminution associée audit détecteur de niveau.

6. Dispositif d'égalisation dynamique selon la revendication 5 dans lequel ladite première constante de temps est une constante de temps d'attaque rapide et ladite seconde constante de temps est une constante de temps de diminution lente.

7. Procédé d'égalisation dynamique comprenant les étapes consistant à,
détecter le niveau d'un signal d'entrée audio pour fournir un signal de niveau d'entrée détecté,
détecter le réglage d'un organe de commande du volume (13) actionné manuellement ;
la détection dudit niveau du signal d'entrée audio se produisant avant que le signal d'entrée ne soit envoyé vers ledit organe de commande du volume (13) actionné manuellement,
traiter le signal audio après qu'il ait eu son volume ajusté par ledit organe de commande du volume (13) réglé manuellement avec une réponse en fréquence ajustable réglée en réponse à la fois au signal de niveau d'entrée détecté et au réglage de l'organe de commande du volume actionné manuellement,
et limiter la plage dynamique du signal de niveau d'entrée détecté.

8. Procédé d'égalisation dynamique selon la revendication 7 et comprenant en outre les étapes consistant à,
additionner ledit signal de niveau d'entrée et ledit signal de réglage de l'organe de commande du volume contrôlé manuellement pour fournir un signal à niveaux combinés de réglage du volume,
appliquer la sortie de l'organe de commande du volume (13) contrôlé manuellement à un filtre (36) de composantes spectrales basses **caractérisé par** une fréquence centrale située à une fréquence basse déterminée,
traiter le signal de réglage du volume à niveaux combinés pour fournir un signal représentatif d'un gain souhaité qui est dépendant du niveau du signal d'entrée et du réglage de l'organe de commande du volume réglé manuellement,
appliquer la sortie du filtre (36) à un organe de commande du gain (35) ayant son gain réglé sur ledit gain souhaité,
et additionner la sortie dudit organe de commande du gain (35) au signal de sortie de l'organe de commande du volume contrôlé manuellement pour fournir un signal de sortie égalisé dynamiquement.

9. Procédé d'égalisation dynamique selon la revendication 8 dans lequel le traitement du signal de volume à niveaux combinés comprend une application de ce dernier signal à une table de conversion (33) pour fournir ledit signal représentatif d'un gain souhaité.

10. Procédé selon la revendication 7 et permettant au signal de niveau d'entrée détecté d'augmenter selon une première constante de temps d'attaque et de diminuer selon une seconde constante de temps de diminution différente de ladite première constante de temps.

11. Dispositif d'égalisation dynamique comprenant,
une borne d'entrée (11) et une borne de sortie (12),
un organe de commande du volume (13) contrôlé manuellement situé entre ladite borne d'entrée (11) et ladite borne de sortie (12),
un détecteur de niveau (15) ayant son entrée couplée à ladite borne d'entrée et fournissant un signal de niveau représentatif du niveau présent sur ladite borne d'entrée (11),
un limiteur (17) couplé audit détecteur de niveau (15) construit et organisé pour limiter la plage dynamique dudit signal de niveau,
un filtre (36) ayant son entrée couplée à la sortie dudit organe de commande du volume (13) contrôlé manuellement,
un processeur de signal situé entre le détecteur de niveau (15) et le filtre (36) construit et organisé pour fournir un signal de gain représentatif d'un gain souhaité qui est dépendant du niveau du signal d'entrée et du réglage de l'organe de commande du volume réglé manuellement, et
un organe de commande du gain (35) situé entre le filtre (36) et ladite sortie construit et organisé pour établir ledit gain souhaité en réponse audit signal de gain.
